# EUROPÄISCHE PATENTANMELDUNG

(11) **EP 0 529 183 A2**
(43) Veröffentlichungstag der Anmeldung: **03.03.1993**
(21) Anmeldenummer: 92102173.9
(22) Anmeldetag: 10.02.1992
(51) Int. Cl.: H04B 1/16, H03J 5/02

(54) **Autoradio**

(30) Priorität: 24.08.1991 DE 4128129
(71) Anmelder: Blaupunkt-Werke GmbH, D-31132 Hildesheim (DE)
(72) Erfinder: Vogt, Lothar, Dr., W-3156 Hohenhameln (DE); Bartels, Stefan, Dr., W-3200 Hildesheim (DE); Chahabadi, Djahanyar, Dr., W-3200 Hildesheim (DE); Nyenhuis, Detlev, W-3226 Sibbesse (DE)

(57) **Zusammenfassung**

Es wird ein neues Autoradio beschrieben, das mit einer Schaltung zur Analog-Digital-Wandlung des zwischenfrequenten Signals ausgerüstet ist und über einen in der Phase geregelten Mischoszillator verfügt. Als Referenzoszillator für die Phasenregelung wird der Taktgenerator des Analog-Digital-Wandlers eingesetzt.

## Beschreibung

Das Schutzrecht betrifft ein neues Autoradio mit einer Schaltungsanordnung zur Analog-Digital-Wandlung des zwischenfrequenten Signals.

Für ein Autoradio dieser Art ist in der älteren Patentanmeldung P 41 048 82.2 der Vorschlag näher erläutert worden, einen Sigma-Delta-Wandler mit einer Taktfrequenz zu takten, die in einem vorgegebenen Verhältnis zur Bandbreite des Zwischenfrequenzsignals steht. Bei weiteren Arbeiten an dem Aufbau eines Empfängers mit einem analogen Empfangsteil, in dem das zwischenfrequente Signal erzeugt wird und einem digitalen Signalbearbeitungsteil für die Nutzmodulation des empfangenen Senders, deren Schnittstelle ein A/D-Wandler am Ausgang des ZF-Verstärkers ist, wurde gefunden, daß sich die Frequenzprobleme im Empfänger dann besonders einfach beherrschen lassen, wenn erfindungsgemäß der Mischoszillator in der Phase geregelt ist und der Referenzoszillator für die Phasenregelung der Taktgenerator des Analog-Digital-Wandlers ist.

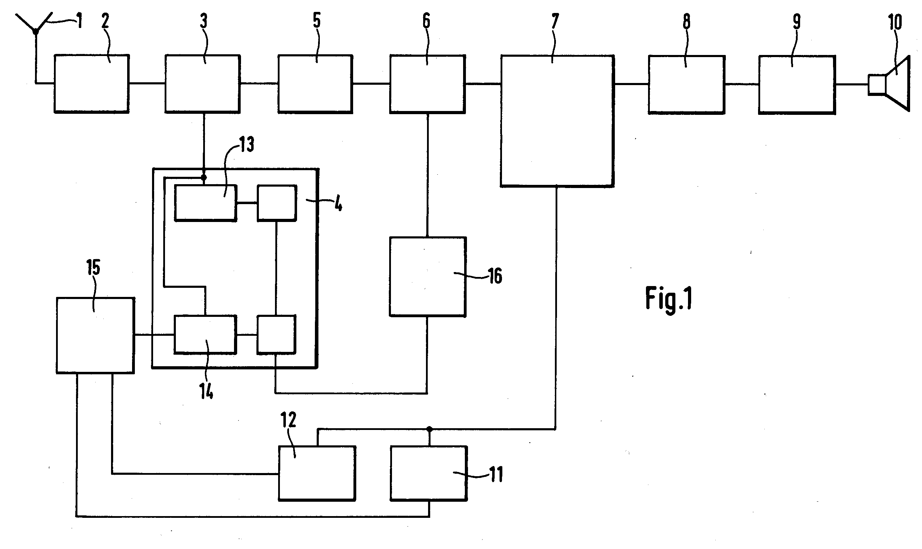

Die Erfindung wird anhand des in Figur 1 dargestellten Blockschaltbildes eines erfindungsgemäßen Autoradios näher erläutert.

Die mit der Antenne 1 empfangenen Sendersignale werden über eine Antennenankoppelstufe 2 auf den ersten Eingang einer Mischstufe 3 geleitet. Der zweite Eingang der Mischstufe 3 ist an einen Mischoszillator 4 angeschlossen, der später näher erläutert wird. In der Mischstufe 3 wird das Nutzsignal eines gewünschten Programmsenders von dessen Träger auf die geräteeigene Zwischenfrequenz umgesetzt. Das Ausgangssignal der Mischstufe 3 wird in der ZF-Stufe 5 verstärkt und in seiner Bandbreite begrenzt.

Bis zum Ausgang der ZF-Stufe erfolgt die Signalverarbeitung analog. An dem Ausgang der ZF-Stufe 5 ist ein Analog-Digital-Wandler 6 angeschlossen. Ein Ausführungsbeispiel eines solchen Analog-Digital-Wandlers ist u. a. in der älteren Patentanmeldung P 41 06 928 beschrieben. An den A/D-Wandler 6 schließt sich ein digital ausgeführter ZF-Demodulator 7 an, in dem die Nutzinformation des eingestellten Senders zurückgewonnen wird. Diese Nutzinformation besteht aus dem akustischen Nutzsignal und ggf. aus Verkehrsfunkkennungen und RDS-Signalen. Das akustische Nutzsignal wird hinsichtlich Lautstärke, Klang usw. in dem Demodulator digital bearbeitet und über Digital-Analog-Wandlerstufen 8 in analoge Signale zurückgewandelt, die in einer NF-Stufe 9 verstärkt und über den Lautsprecher 10 wiedergegeben werden, während die anderen Nutzsignale in geeigneten Decodern 11 und 12 ausgewertet werden.

Der Mischoszillator 4 ist ein phasengeregelter Oszillator 13, dessen Frequenz über einen steuerbaren Teiler 14 auf die Referenzfrequenz heruntergeteilt wird. Das Teilerverhältnis wird von einem Abstimmprozessor 15 gesteuert, der u. a. auch Signale der Decoder 11 und 12 auswertet.

Der Analog-Digital-Wandler 6 tastet das analoge ZF-Signal in vorgegebenen Zeitpunkten ab, die von einem Taktgenerator 16 bestimmt werden. Dieser Taktgenerator 16 ist erfindungsgemäß zugleich der Referenzoszillator für den Mischoszillator 4.

Bei der Auswertung des Nutzsignal des Senders treten in dem digital arbeitenden Empfangsteil auch ein Hilfsträger von 57 kHz und ein 19-kHz-Pilotton zur Rückgewinnung der Verkehrsfunkkennungen, der RDS-Signale und der Stereoton-Signale auf. Zur Vermeidung von störenden Mischprodukten beträgt die Frequenz des Taktgenerators gemäß einer weiteren Erfindung ein Vielfaches dieser beiden Frequenzen.

Die handelsüblichen ZF-Schaltungen sind alle für eine Zwischenfrequenz von 10,7 MHz ausgelegt. Für die Zwischenfrequenz im vorliegenden Ausführungsbeispiel der weiteren Erfindung ist der Wert der Zwischenfrequenz mit 10,6875 MHz gewählt, einem der 10,7 MHz nächstliegenden vielfachen von 57 kHz.

Die Frequenz des Taktgenerators ist im vorliegenden Ausführungsbeispiel beider Erfindungen auf 42,75 MHz festgelegt, dem Vierfachen des gewählten Wertes der Zwischenfrequenz.

## Patentansprüche

1. Autoradio mit einer Schaltung zur Analog-Digital-Wandlung des Zwischenfrequenzsignals, dadurch gekennzeichnet,
daß der Mischoszillator (4) in der Phase geregelt ist und der Referenzoszillator (16) für die Phasenregelung der Taktgenerator des Analog-Digital-Wandlers (6) ist.

2. Autoradio nach Anspruch 1,
dadurch gekennzeichnet,
daß die Frequenz des Taktgenerators ein Vielfaches von 57 kHz beträgt.

3. Autoradio nach Anspruch 4,
dadurch gekennzeichnet,
daß die Frequenz des Taktgenerators 42,75 MHz beträgt.

4. Autoradio, insbesondere nach Anspruch 1,
dadurch gekennzeichnet,
daß der Wert der Zwischenfrequenz ein Vielfaches von 57 kHz beträgt.

5. Autoradio nach Anspruch 4,
dadurch gekennzeichnet,
daß der Wert der Zwischenfrequenz 10,6875 Mhz beträgt.
